# EUROPEAN PATENT APPLICATION

(11) **EP 1 901 079 A1**
(43) Date of publication of application: **19.03.2008**
(21) Application number: 06766970.5
(22) Date of filing: 20.06.2006
(51) Int. Cl.: G01R 31/302, H01L 21/66

(54) **SEMICONDUCTOR DEFECT ANALYZING DEVICE, DEFECT ANALYZING METHOD, AND DEFECT ANALYZING PROGRAM**

(30) Priority: 22.06.2005 JP 2005182627
(71) Applicant: HAMAMATSU PHOTONICS K.K., Hamamatsu-shi, Shizuoka-ken 435-8558 (JP)
(72) Inventor: MAJIMA, Toshiyuki c/o Renesas Technology Corp., Kodaira-shi, Tokyo 1878588 (JP); SHIMASE, Akira c/o Renesas Technology Corp., Kodaira-shi, Tokyo 1878588 (JP); TERADA, Hirotoshi c/o Hamamatsu Photonics K.K., Hamamatsu-shi, Shizuoka 4358558 (JP); HOTTA, Kazuhiro c/o Hamamatsu Photonics K.K., Hamamatsu-shi, Shizuoka 4358558 (JP); TAKEDA, Masahiro c/o Hamamatsu Photonics K.K., Hamamatsu-shi, Shizuoka 4358558 (JP)
(74) Representative: Grünecker, Kinkeldey, Stockmair & Schwanhäusser Anwaltssozietät
(86) International application number: PCT/JP2006/312309
(87) International publication number: WO 2006/137391

(57) **Abstract**

A failure analysis apparatus 10 is composed of an inspection information acquirer 11 for acquiring a failure observed image P2 of a semiconductor device, a layout information acquirer 12 for acquiring layout information, a failure analyzer 13 for analyzing a failure of the semiconductor device, and an analysis screen display controller 14 for letting a display device 40 display information about a result of the analysis. The failure analyzer 13 sets an analysis region with reference to the failure observed image P2, and extracts a net passing the analysis region, from a plurality of nets included in a layout of the semiconductor device. This substantializes a semiconductor failure analysis apparatus, analysis method, and analysis program capable of securely and efficiently performing the analysis of the failure of the semiconductor device.

## Description

### Technical Field

The present invention relates to a semiconductor failure analysis apparatus, failure analysis method, and failure analysis program for analyzing a failure of a semiconductor device.

### Background Art

The conventionally available semiconductor inspection apparatus for acquiring an observed image for analysis of failure of a semiconductor device include emission microscopes, OBIRCH apparatus, time-resolved emission microscopes, and so on. These inspection apparatus are able to analyze such a failure as a broken part in a semiconductor device by use of an emission image or OBIRCH image acquired as a failure observed image (e.g., reference is made to Patent Documents 1 and 2).
Patent Document 1: Japanese Patent Application Laid-Open No. 2003-86689
Patent Document 2: Japanese Patent Application Laid-Open No. 2003-303746

### Disclosure of the Invention

### Problems to be Solved by the Invention

In recent years, semiconductor devices as analysis objects in the semiconductor failure analysis have been miniaturized and integrated more and more, and it has become difficult to perform the analysis of failure part by means of the aforementioned inspection apparatus. In order to analyze the failure part of such a semiconductor device, it is thus essential to improve certainty and efficiency of the analysis process for estimating the failure part of the semiconductor device from the failure observed image.

The present invention has been accomplished in order to solve the above problem, and an object of the invention is to provide a semiconductor failure analysis apparatus, failure analysis method, and failure analysis program capable of securely and efficiently performing an analysis of a failure of a semiconductor device with use of a failure observed image.

### Means for Solving the Problem

In order to achieve the above object, a semiconductor failure analysis apparatus according to the present invention is a semiconductor failure analysis apparatus for analyzing a failure of a semiconductor device, using an observed image thereof, comprising: (1) inspection information acquiring means for acquiring a failure observed image containing reaction information arising from a failure, acquired by conducting an inspection about the failure, as an observed image of the semiconductor device; (2) layout information acquiring means for acquiring layout information of the semiconductor device; (3) failure analyzing means for analyzing the failure of the semiconductor device with reference to the failure observed image and the layout information; and (4) information display controlling means for letting display means display information about an analysis of the failure of the semiconductor device, (5) wherein the failure analyzing means has region setting means for setting an analysis region in correspondence to the reaction information with reference to the failure observed image, and net information analyzing means for extracting a net passing the analysis region, from a plurality of nets included in a layout of the semiconductor device, and (6) wherein the information display controlling means lets the display means display information about a result of the analysis of the failure of the semiconductor device obtained by the region setting means and the net information analyzing means.

A semiconductor failure analysis method according to the present invention is a semiconductor failure analysis method of analyzing a failure of a semiconductor device, using an observed image thereof, comprising: (a) an inspection information acquiring step of acquiring a failure observed image containing reaction information arising from a failure, acquired by conducting an inspection about the failure, as an observed image of the semiconductor device; (b) a layout information acquiring step of acquiring layout information of the semiconductor device; (c) a region setting step of setting an analysis region in correspondence to the reaction information with reference to the failure observed image; (d) a net information analyzing step of extracting a net passing the analysis region, from a plurality of nets included in a layout of the semiconductor device; and (e) an information displaying step of letting display means display information about a result of the analysis of the failure of the semiconductor device obtained by the region setting step and the net information analyzing step.

A semiconductor failure analysis program according to the present invention is a program for letting a computer execute a semiconductor failure analysis of analyzing a failure of a semiconductor device, using an observed image thereof, the semiconductor failure analysis program letting the computer execute: (a) an inspection information acquiring process of acquiring a failure observed image containing reaction information arising from a failure, acquired by conducting an inspection about the failure, as an observed image of the semiconductor device; (b) a layout information acquiring process of acquiring layout information of the semiconductor device; (c) a region setting process of setting an analysis region in correspondence to the reaction information with reference to the failure observed image; (d) a net information analyzing process of extracting a net passing the analysis region, from a plurality of nets included in a layout of the semiconductor device; and (e) an information displaying process of letting display means display information about a result of the analysis of the failure of the semiconductor device obtained by the region setting process and the net information analyzing process.

The above-described semiconductor failure analysis apparatus, failure analysis method, and failure analysis program are arranged to acquire the failure observed image such as an emission image or OBIRCH image acquired by conducting an inspection of the semiconductor device as an analysis object, and necessary information about the layout of the semiconductor device. Then the analysis region is set in correspondence to the reaction information (e.g., information about a reaction part) in the failure observed image, and a net passing the analysis region is extracted out of the nets constituting the semiconductor device, thereby performing the analysis of the failure of the semiconductor device. This configuration permits us to estimate a net with a high possibility of failure in the semiconductor device by suitably setting the analysis region and extracting the net passing the analysis region. Therefore, it becomes feasible to securely and efficiently perform the analysis of the failure of the semiconductor device with the use of the failure observed image.

### Effects of the Invention

Since the semiconductor failure analysis apparatus, failure analysis method, and failure analysis program of the present invention are arranged to set the analysis region in correspondence to the reaction information in the failure observed image and to extract a net passing the analysis region out of the nets in the layout of the semiconductor device, they permit us to estimate a net with a high possibility of failure in the semiconductor device by suitably setting the analysis region and extracting a net passing the analysis region. Therefore, it becomes feasible to securely and efficiently perform the analysis of the failure of the semiconductor device with the use of the failure observed image.

### Brief Description of the Drawings

[FIG 1] Fig. 1 is a block diagram showing a configuration of an embodiment of the failure analysis system incorporating the semiconductor failure analysis apparatus.
[FIG 2] Fig. 2 is a block diagram showing a specific configuration of a failure analyzer.
[FIG 3] Fig. 3 is a drawing schematically showing a semiconductor failure analysis method.
[FIG 4] Fig. 4 is a drawing schematically showing acquisition of a failure observed image.
[FIG 5] Fig. 5 is a configuration diagram showing an example of semiconductor inspection apparatus.
[FIG 6] Fig. 6 is a configuration diagram as a side view of the semiconductor inspection apparatus shown in Fig. 5.
[FIG 7] Fig. 7 is a configuration diagram showing an example of an analysis window displayed in a display device.
[FIG 8] Fig. 8 is a drawing schematically showing an image displayed in an image display region.
[FIG 9] Fig. 9 is a configuration diagram showing an example of an operation screen displayed in an analysis operation region.
[FIG 10] Fig. 10 is a configuration diagram showing another example of an operation screen displayed in an analysis operation region.
[FIG. 11] Fig. 11 is a configuration diagram showing another example of an operation screen displayed in an analysis operation region.
[FIG 12] Fig. 12 is a configuration diagram showing an example of a display window displayed in a display device.

### Description of Symbols

1- semiconductor failure analysis system, 10 - semiconductor failure analysis apparatus, 11 - inspection information acquirer, 12 - layout information acquirer, 13 - failure analyzer, 131 - region setter, 132 - net information analyzer, 133 - position adjuster, 134 - additional analysis information acquirer, 14 - analysis screen display controller, 15 - layout image display controller, 20 - inspection information supplying apparatus, 20A - semiconductor inspection apparatus, 21 - observation section, 22 - control section, 23 - inspection information processor, 24 - display device, 30 - layout information supplying apparatus, 40 - display device, 45 - input device,
P1 - pattern image, P2 - failure observed image, P3 - layout image, P4 - emission image, P5 - OBIRCH image, P6 - superimposed image, A 1 to A6 - emission region, B 1 to B6 - analysis region, C 1 to C4 - net.

### Best Modes for Carrying Out the Invention

Preferred embodiments of the semiconductor failure analysis apparatus, failure analysis method, and failure analysis program according to the present invention will be described below in detail with reference to the drawings. In the description of the drawings the same elements will be denoted by the same reference symbols, without redundant description. It is also noted that dimensional ratios in the drawings do not always agree with those in the description.

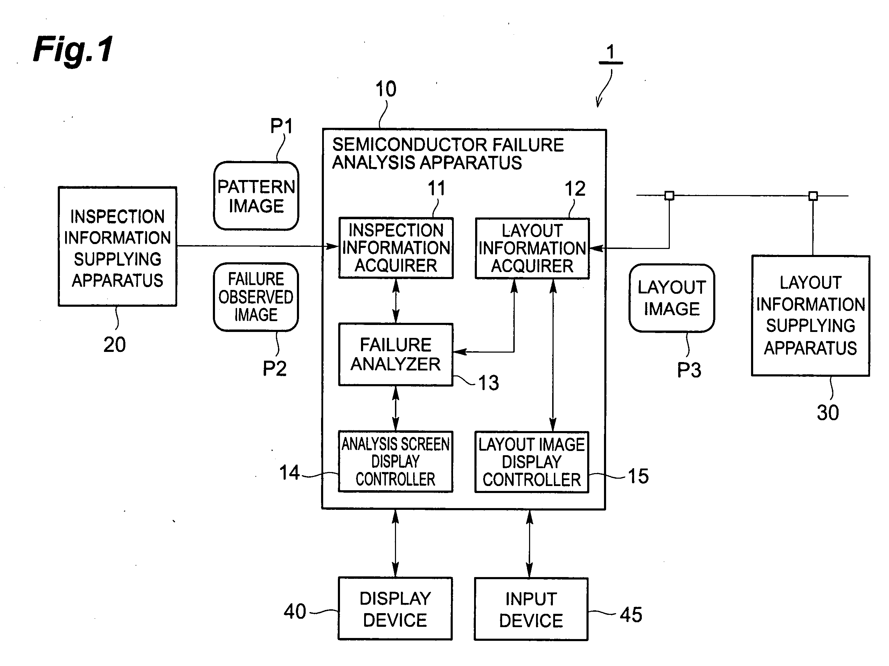

Fig. 1 is a block diagram schematically showing a configuration of an embodiment of the failure analysis system incorporating the semiconductor failure analysis apparatus according to the present invention. The present failure analysis system 1 is a system an analysis object of which is a semiconductor device and which is for carrying out an analysis of a failure with the use of an observed image thereof, and the system comprises a semiconductor failure analysis apparatus 10, an inspection information supplying apparatus 20, a layout information supplying apparatus 30, a display device 40, and an input device 45. Configurations of the semiconductor failure analysis apparatus 10 and failure analysis system 1 will be described below along with a semiconductor failure analysis method.

The semiconductor failure analysis apparatus 10 is an analysis apparatus for importing data necessary for the analysis of the failure of the semiconductor device and executing the analysis processing of the failure. The failure analysis apparatus 10 according to the present embodiment has an inspection information acquirer 11, a layout information acquirer 12, a failure analyzer 13, an analysis screen display controller 14, and a layout image display controller 15. Devices connected to the failure analysis apparatus 10 include the display device 40 for displaying information about the failure analysis, and the input device 45 used for instructions necessary for the failure analysis and for input of information necessary for the failure analysis.

Data to be used in the failure analysis executed in the failure analysis apparatus 10 is acquired by the inspection information acquirer 11 and by the layout information acquirer 12. The inspection information acquirer 11 acquires a pattern image P1 being a normal observed image, and a failure observed image P2 containing reaction information arising from a failure, obtained by conducing an inspection about the failure, as observed images of the semiconductor device (inspection information acquiring step). The layout information acquirer 12 acquires layout information indicating a configuration of nets or the like in the semiconductor device (layout information acquiring step). In Fig. 1, the layout information acquirer 12 acquires a layout image P3 as the layout information of the semiconductor device.

In Fig. 1, the inspection information supplying apparatus 20 is connected to the inspection information acquirer 11, and the pattern image P1 and the failure observed image P2 are supplied from the supplying apparatus 20 to the acquirer 11. This inspection information supplying apparatus 20 can be, for example, an emission microscope apparatus. In this case, the failure observed image P2 is an emission image. The inspection information supplying apparatus 20 can also be an OBIRCH apparatus. In this case, the failure observed image P2 is an OBIRCH image. Furthermore, the supplying apparatus 20 may also be any other type of semiconductor inspection apparatus than those.

Where the pattern image P1 and the failure observed image P2 are those preliminarily acquired by the semiconductor inspection apparatus, the inspection information supplying apparatus 20 is a data storage device storing those image data. The data storage device in this case may be one provided inside the failure analysis apparatus 10, or an external device. This configuration is useful in a case where observed images are taken and stored in advance by the semiconductor inspection apparatus and where software of failure analysis apparatus 10 is executed on another computer. In this case, works of the failure analysis can be performed as shared, without occupying the semiconductor inspection apparatus.

The pattern image P1 and the failure observed image P2 acquired by the semiconductor inspection apparatus such as the emission microscope apparatus or OBIRCH apparatus are acquired as images P1, P2 in a state in which the semiconductor device is mounted on a stage. For this reason, they are acquired as images aligned relative to each other.

On the other hand, the layout information supplying apparatus 30 is connected through a network to the layout information acquirer 12, and the layout image P3 is supplied from the supplying apparatus 30 to the acquirer 12. This layout information supplying apparatus 30 can be, for example, a workstation on which a CAD software application of a layout viewer to generate the layout image P3 from design information such as arrangement of elements and nets (wirings) constituting the semiconductor device, is running.

The failure analysis apparatus 10 is preferably configured to acquire the layout information other than the layout image P3, e.g., individual information of a plurality of nets contained in the semiconductor device, by performing communication with the layout information supplying apparatus 30 as occasion may demand. Alternatively, the failure analysis apparatus 10 may also be configured to load the information together with the layout image P3 from the layout information acquirer 12.

In the present embodiment the failure analysis apparatus 10 is provided with the layout image display controller 15. This layout image display controller 15 is comprised of screen transfer software, e.g., an X terminal, and has a function of displaying the layout image P3 drawn by the layout information supplying apparatus 30, in a predetermined display window in the display device 40. However, the layout image display controller 15 of this configuration does not always have to be provided if it is not necessary.

The pattern image P1, failure observed image P2, and layout image P3 acquired by the inspection information acquirer 11 and by the layout information acquirer 12 are fed to the failure analyzer 13. The failure analyzer 13 is an analyzing means for analyzing a failure of the semiconductor device with reference to the failure observed image P2 and layout information. The analysis screen display controller 14 is an information display controlling means for letting the display device 40 display the information about the analysis result of the failure of the semiconductor device obtained by the failure analyzer 13. The analysis screen display controller 14 displays the information about the analysis of the failure of the semiconductor device except for the analysis result in a predetermined analysis screen according to need.

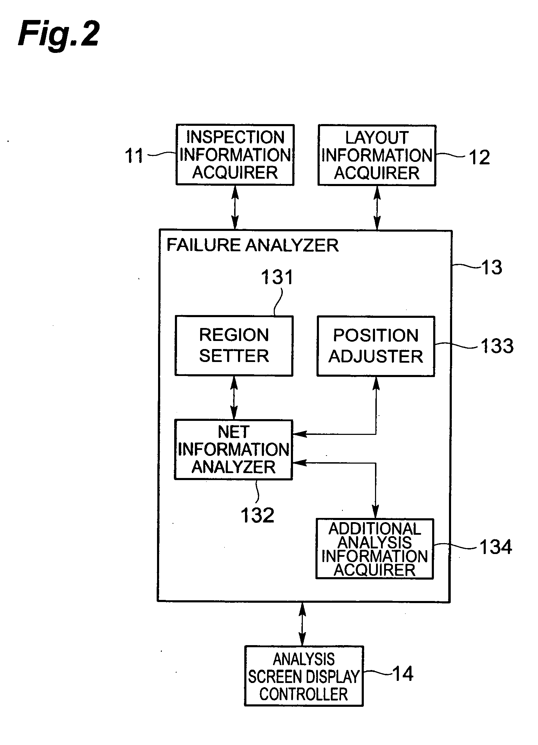

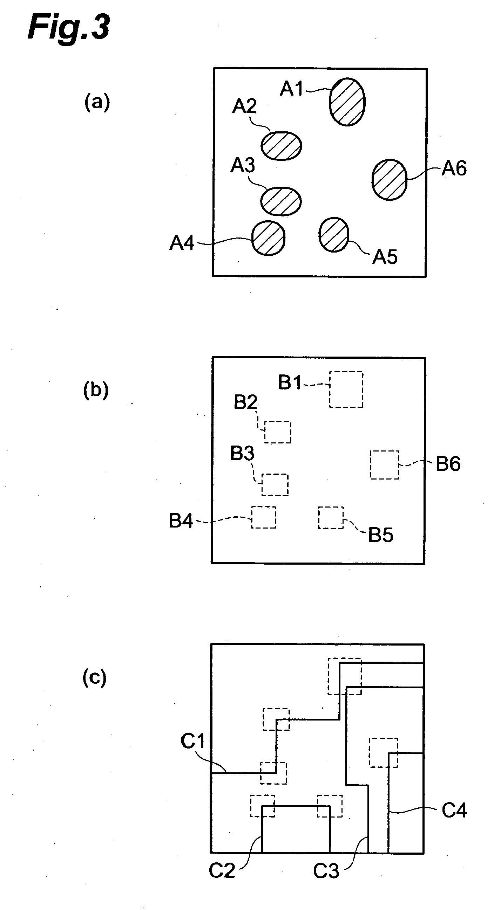

Fig. 2 is a block diagram showing a specific configuration of the failure analyzer 13 in the semiconductor failure analysis apparatus 10 shown in Fig. 1. The failure analyzer 13 of the present embodiment has a region setter 131 and a net information analyzer 132. Fig. 3 is a drawing schematically showing a failure analysis method executed by the region setter 131 and net information analyzer 132.

The region setter 131 is a setting means for setting an analysis region in correspondence to reaction information in the image P2, with reference to the failure observed image P2, for the semiconductor device as an analysis object. Let us consider an emission image acquired by an emission microscope apparatus, as an example of the failure observed image P2. For example, in an example shown in (a) in Fig. 3, six emission regions A1-A6 (reaction regions) exist as the reaction information referenced in the failure analysis, in an emission image. For this image, the region setter 131 sets six analysis regions B1-B6 corresponding to the emission regions, as shown in (b) in Fig. 3 (region setting step).

This setting of analysis regions is preferably manually carried out according to operator's input through the input device 45 using a keyboard, a mouse, and so on. Alternatively, the setting may be arranged to be automatically carried out in the region setter 131. There are no particular restrictions on the shape of the analysis regions thus set, but they are preferably set in the rectangular shape as shown in (b) in Fig. 3, in terms of easiness of analysis or the like. The analysis regions are preferably set wider than the reaction regions in the failure observed image P2, in consideration of positional accuracy of the stage on which the semiconductor device is mounted during inspection.

The net information analyzer 132 performs an analysis of a plurality of nets (wirings) included in the layout of the semiconductor device, with reference to the analysis regions set by the region setter 131. Specifically, it extracts a net passing a set analysis region, from the plurality of nets (net information analyzing step). Where a plurality of analysis regions are set by the region setter 131, the net information analyzer 132 extracts a net passing each of the analysis regions, from the plurality of nets, and acquires a passage count of the net through the analysis regions.

In the example described above, as shown in (c) in Fig. 3, four nets C1-C4 are extracted as nets passing the analysis regions, with the six analysis regions B1-B6 set by the region setter 131. Among these nets C1-C4, the net C1 has the largest passage count of 3 through the analysis regions, the net C2 the passage count of 2, and each of the nets C3, C4 the passage count of 1.

In the analysis of such net information, it is preferable to execute the analysis by carrying out communication with the layout information supplying apparatus 30 through the layout information acquirer 12 as occasion may demand. An example of this configuration is such that the net information analyzer 132 is arranged to instruct the layout information supplying apparatus 30 to extract nets and to acquire the passage counts through the analysis regions, and to receive the result thereof.

The analysis screen display controller 14 lets the display device 40 display the information such as these images necessary for the failure analysis, or the information obtained as the analysis result, as an analysis screen according to need. Particularly, in the present embodiment, the analysis screen display controller 14 lets the display device 40 display information about the nets extracted by the net information analyzer 132 and the passage counts of the nets through the analysis regions, as information indicating the analysis result by the failure analyzer 13 (information displaying step).

The display of the analysis result may be implemented, for example, by displaying an image containing the analysis regions and nets as shown in (c) in Fig. 3, or by displaying names of the nets and counts of passages or the like. Specifically, the analysis screen display controller 14 preferably lets the display device 40 display a net list to display a list of nets extracted by the net information analyzer 132, as the analysis result. Where a plurality of analysis regions are set, the analysis screen display controller 14 preferably lets the display device 40 display a net list to display a list of nets (e.g., names of nets) extracted by the net information analyzer 132, and the passage counts of the nets through the analysis regions (e.g., counts indicating passages), as the analysis result.

Where the analysis result is displayed by an image including the set analysis regions and the extracted nets, the extracted nets may be indicated by highlight display on the layout image, as shown in (c) in Fig. 3. It is also possible to use a variety of specific display methods; e.g., where one of the extracted nets is selected by manipulation of a mouse or the like, the analysis regions where the net passes is displayed by a different color.

The failure analyzer 13 of the present embodiment is provided with a position adjuster 133, corresponding to the configuration wherein the inspection information acquirer 11 acquires the pattern image P 1 in addition to the failure observed image P2. The position adjuster 133 performs position adjustment between the observed images from the inspection information supplying apparatus 20 including the pattern image P1 and failure observed image P2, and the layout image P3 from the layout information supplying apparatus 30, with reference to the pattern image P1 and the layout image P3 (position adjustment step). This position adjustment can be performed, for example, by a method of designating three appropriate points in the pattern image P1, further designating three corresponding points in the layout image P3, and performing the position adjustment from coordinates of those points.

The failure analyzer 13 is provided with an additional analysis information acquirer 134. The additional analysis information acquirer 134 acquires additional analysis information about the failure of the semiconductor device acquired by another analysis method than the aforementioned analysis method by the region setter 131 and the net information analyzer 132, from an external device or the like (additional analysis information acquiring step). This additional analysis information acquired is referenced in combination with the analysis result acquired by the net information analyzer 132.

The effects of the semiconductor failure analysis apparatus and semiconductor failure analysis method according to the above embodiment will be described below.

The semiconductor failure analysis apparatus 10 shown in Fig. 1, and the failure analysis method are arranged to acquire the failure observed image P2 obtained by inspecting the semiconductor device as an analysis object, and the necessary information about the layout of the semiconductor device. Then the region setter 131 sets the analysis region in correspondence to the reaction information arising from a failure in the failure observed image P2 (e.g., information about reaction part, specifically, information about an emission part in an emission image or the like), and the net information analyzer 132 extracts a net passing the analysis region out of the nets constituting the semiconductor device, thereby performing the analysis of the failure of the semiconductor device. This configuration permits the apparatus and method to estimate a net with a high possibility of a failure (suspect failure net) out of the huge number of nets in the semiconductor device, by suitably setting the analysis region and extracting the net passing the analysis region. Therefore, it becomes feasible to securely and efficiently perform the analysis of the failure of the semiconductor device with the use of the failure observed image P2.

The failure analysis system 1 composed of the above-described semiconductor failure analysis apparatus 10, inspection information supplying apparatus 20, layout information supplying apparatus 30, and display device 40 substantializes a semiconductor failure analysis system capable of securely and efficiently carrying out the analysis of the failure of the semiconductor device with the use of the failure observed image P2.

Here the reaction information arising from the failure in the failure observed image P2 contains not only a case where the reaction part itself is a failure part, but also a portion where reaction occurs due to another failure part (e.g., failure net). The above configuration permits the apparatus to suitably perform narrowing and estimation with the use of the reaction information, for such failure nets or the like.

Concerning the analysis region set in correspondence to the reaction information in the failure observed image P2, a preferred configuration is as follows where the region setter 131 sets a plurality of analysis regions: the net information analyzer 132 extracts a net passing each of the analysis regions, from the plurality of nets included in the layout of the semiconductor device, and acquires a passage count of the net through the analysis regions. This configuration permits the apparatus to estimate a net with a high possibility of failure in the semiconductor device, by extracting a net having a large passage count through the analysis regions. Therefore, it becomes feasible to more securely and efficiently perform the analysis of the failure of the semiconductor device with the use of the failure observed image P2.

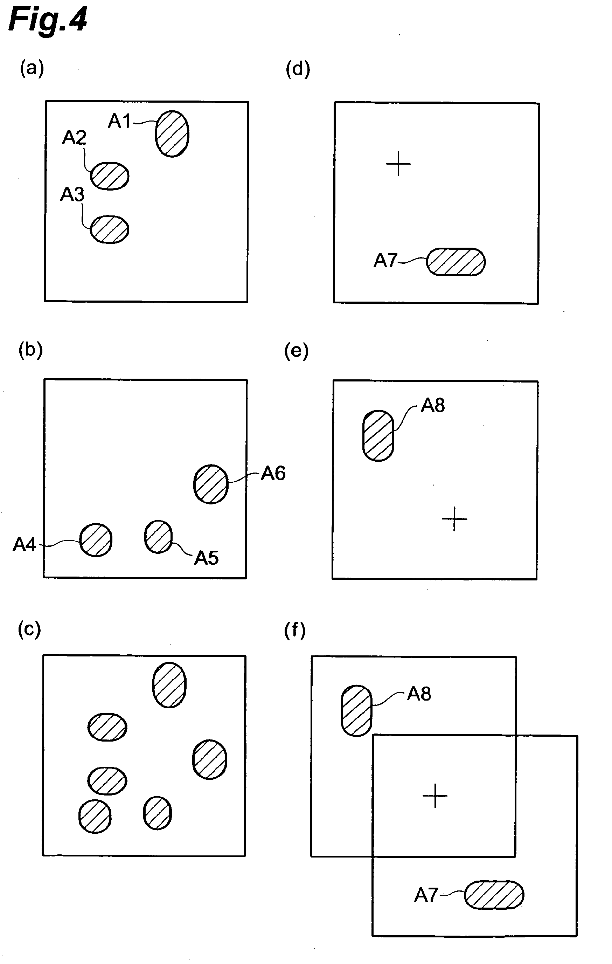

The emission image was exemplified as the failure observed image P2 used in the failure analysis, in (a) in Fig. 3, but a similar failure analysis method can also be applied, for example, to cases using another observed image such as an OBIRCH image. The failure observed image shown in (a) in Fig. 3 can be an image obtained by a single observation under a single condition, but the failure observed image is not limited to it; for example, as shown in Fig. 4, the failure observed image can be a superimposed image as shown in (c) in Fig. 4 of a failure observed image of (a) in Fig. 4 acquired under a first condition and a failure observed image of (b) in Fig. 4 acquired under a second condition different from the first condition.

In the acquisition of the failure observed image under the second condition described above, it can also be contemplated that an observation position is changed from that in the first condition (e.g., a position or range in the failure observed image is changed), as shown in (d) and (e) in Fig. 4. In such cases, as shown in (f) in Fig. 4, it is preferable to implement the superposition of images in consideration of the change information of the observation position. Another possible method is to store the net names and passage counts obtained under the first condition, into a storage means and to add the net names and passage counts obtained under the second condition. By performing these multiple times, it is feasible to make a distribution of passage frequencies of nets more distinguished.

In the above embodiment the failure analysis apparatus 10 is arranged so that the inspection information acquirer 11 acquires the pattern image P1 in addition to the failure observed image P2, the layout information acquirer 12 acquires the layout image P3 as the layout information, and the position adjuster 133 of the failure analyzer 13 performs the position adjustment of the images with reference to the pattern image P1 and the layout image P3. When the position adjustment is performed with respect to the layout image P3 with the use of the pattern image P1 acquired in the state in which it is aligned with the failure observed image P2 as described above, the accuracy of the analysis of the failure of the semiconductor device can be improved.

Here the region setter 131 of the failure analyzer 13 is preferably arranged to be able to set an attribute for an analysis region. In this case, the net information analyzer 132 may be arranged to select whether the analysis region is to be used in extraction of the net (whether it is to be used in the failure analysis), with reference to the attribute set for the analysis region. Where a plurality of analysis regions are set, the region setter 131 is preferably arranged to be able to set an attribute for each of the analysis regions. In this case, the net information analyzer 132 may be arranged to select whether each analysis region is to be used in extraction of the net and in acquisition of the passage count, with reference to the attributes set for the respective analysis regions. A specific failure analysis method of this type will be described later.

In the above embodiment the failure analysis apparatus 10 is configured so that the additional analysis information acquirer 134 of the failure analyzer 13 acquires the additional analysis information, e.g., information about a suspect failure net, as to the failure of the semiconductor device acquired by another analysis method. By referencing such additional analysis information, it is feasible to further improve the accuracy of the analysis of the failure of the semiconductor device.

Concerning the display of the analysis result in the display device 40, it is preferable to let the display device 40 display a net list to display a list of nets extracted by the net information analysis, or further display passage counts of the nets through the analysis regions, as described above. This permits the operator to carry out the failure analysis work such as estimation of a net with a high possibility of failure in the semiconductor device, with good visibility. Therefore, it becomes feasible to further securely and efficiently perform the analysis of the failure of the semiconductor device with the use of the failure observed image P2. In addition to such list display, the net list may be displayed in a graph form (e.g., a graph form of counts of passages through the analysis regions), with better visibility.

The processing corresponding to the failure analysis method executed in the semiconductor failure analysis apparatus 10 shown in Fig. 1 can be implemented by a semiconductor failure analysis program for letting a computer execute the semiconductor failure analysis. For example, the failure analysis apparatus 10 can be constructed of a CPU for executing each of software programs necessary for the processing of semiconductor failure analysis, a ROM storing the software programs, and a RAM temporarily storing data during execution of the programs. The aforementioned failure analysis apparatus 10 can be substantialized by letting the CPU execute a predetermined failure analysis program in this configuration.

The program for letting the CPU execute each of processes for the semiconductor failure analysis can be recorded in a computer-readable recording medium and distributed in that form. Such recording media include, for example, magnetic media such as hard disks and flexible disks, optical media such as CD-ROM and DVD-ROM, magnetooptic media such as floptical disks, or hardware devices such as RAM, ROM, and semiconductor nonvolatile memories specially arranged to execute or store program commands.

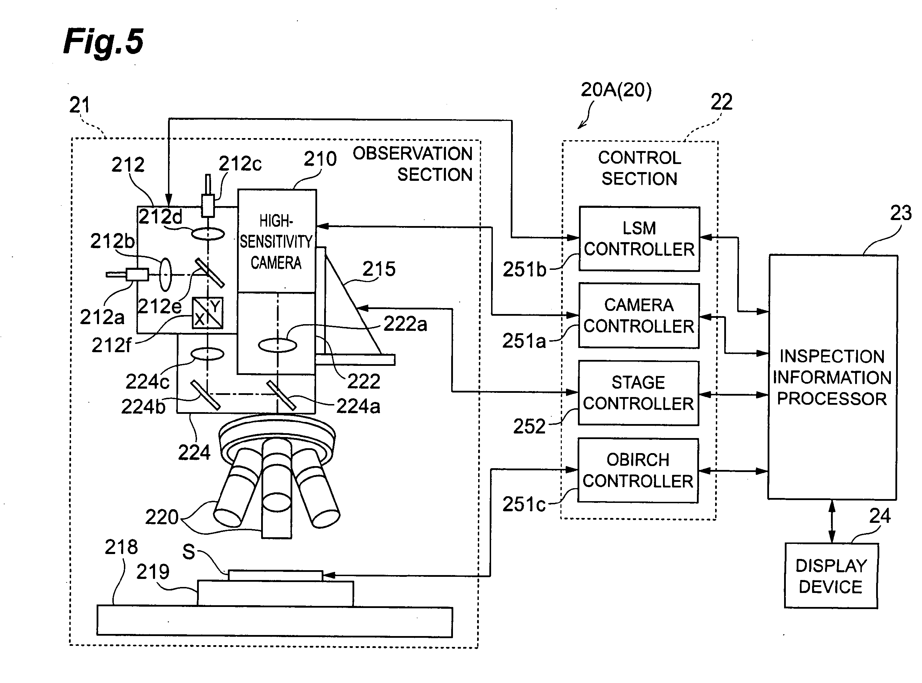

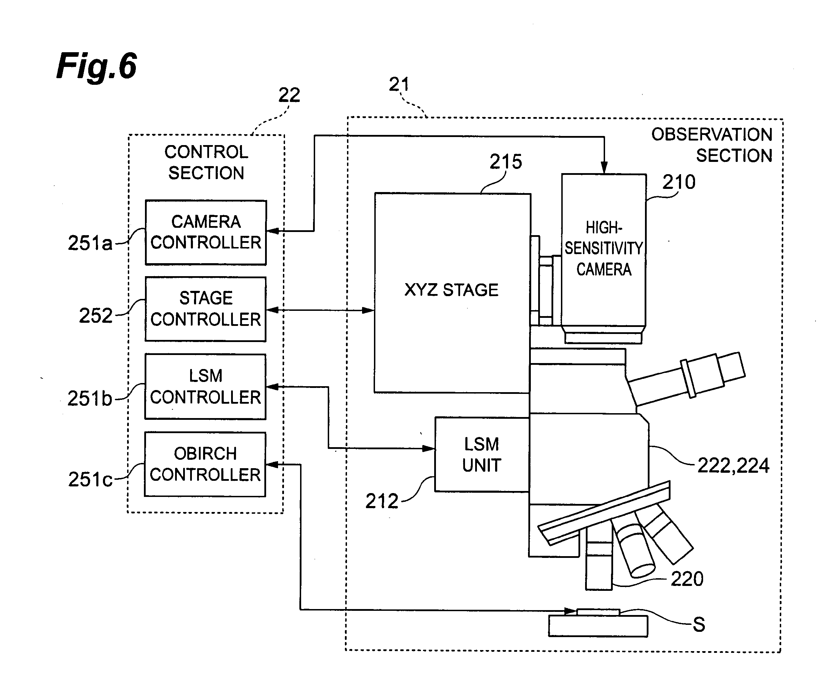

Fig. 5 is a configuration diagram showing an example of semiconductor inspection apparatus which can be applied as the inspection information supplying apparatus 20 shown in Fig. 1. Fig. 6 is a configuration diagram as a side view of the semiconductor inspection apparatus shown in Fig. 5.

The semiconductor inspection apparatus 20A according to the present configuration example comprises an observation section 21 and a control section 22. A semiconductor device S as an inspection object (analysis object to be analyzed by the failure analysis apparatus 10) is mounted on a stage 218 provided in the observation section 21. In the present configuration example, the apparatus is further provided with a test fixture 219 for applying an electric signal or the like necessary for the failure analysis to the semiconductor device S. The semiconductor device S is arranged, for example, so that a back face thereof faces an objective lens 220.

The observation section 21 has a high-sensitivity camera 210 set in a dark box, a laser scan optic (LSM: Laser Scanning Microscope) unit 212, optical systems 222, 224, and an XYZ stage 215. Among these, the camera 210 and LSM unit 212 are image acquiring means for acquiring an observed image of the semiconductor device S (pattern image P1 or failure observed image P2).

The optical systems 222, 224, and the objective lens 220 disposed on the semiconductor device S side of the optical systems 222, 224 constitute a lightguide optical system for guiding an image (optical image) from the semiconductor device S to the image acquiring means. In the present configuration example, as shown in Figs. 5 and 6, a plurality of objective lenses 220 having their respective magnifications different from each other are arranged so as to be switchable from one to another. The test fixture 219 is an inspecting means for performing an inspection for the failure analysis of the semiconductor device S. The LSM unit 212 also has a function as an inspecting means, as well as the function as the aforementioned image acquiring means.

The optical system 222 is a camera optical system for guiding light from the semiconductor device S incident thereto through the objective lens 220, to the camera 210. The camera optical system 222 has an imaging lens 222a for forming an image enlarged at a predetermined magnification by the objective lens 220, on a light-receiving surface inside the camera 210. A beam splitter 224a of the optical system 224 is interposed between the objective lens 220 and the imaging lens 222a. The high-sensitivity camera 210 to be used is, for example, a cooled CCD camera or the like.

In this configuration, light from the semiconductor device S as a failure analysis object is guided through the optical system including the objective lens 220 and the cameral optical system 222, to the camera 210. Then the camera 210 acquires an observed image such as the pattern image P1 of the semiconductor device S. It is also possible to acquire an emission image being a failure observed image P2 of the semiconductor device S. In this case, light generated from the semiconductor device S in a state in which a voltage is applied thereto by the test fixture 219 is guided through the optical system to the camera 210, and the camera 210 acquires an emission image.

The LSM unit 212 has a laser input optical fiber 212a for emitting an infrared laser beam, a collimator lens 212b for collimating the laser beam emitted from the optical fiber 212a, a beam splitter 212e for reflecting the laser beam collimated by the lens 212b, and an XY scanner 212f for emitting the laser beam reflected by the beam splitter 212e, to the semiconductor device S side, while scanning it in XY directions.

The LSM unit 212 further has a condenser lens 212d for condensing light incident thereto from the semiconductor device S side through the XY scanner 212f and transmitted by the beam splitter 212e, and a detection optical fiber 212c for detecting the light condensed by the condenser lens 212d.

The optical system 224 is an optical system for the LSM unit which guides light between the semiconductor device S and objective lens 220, and the XY scanner 212f of the LSM unit 212. The optical system 224 for the LSM unit has a beam splitter 224a for reflecting part of light incident thereto from the semiconductor device S through the objective lens 220, a mirror 224b for changing an optical path of the light reflected by the beam splitter 224a, into an optical path directed toward the LSM unit 212, and a lens 224c for condensing the light reflected by the mirror 224b.

In this configuration, the infrared laser beam emitted from a laser light source through the laser input optical fiber 212a passes the lens 212b, beam splitter 212e, XY scanner 212f, optical system 224, and objective lens 220 to irradiate the semiconductor device S.

Reflectively scattered light of this incident beam from the semiconductor device S reflects a circuit pattern provided in the semiconductor device S. The reflected light from the semiconductor device S passes through an optical path opposite to that of the incident beam to reach the beam splitter 212e, and passes through the beam splitter 212e. Then the light passing through the beam splitter 212e is incident through the lens 212d into the detection optical fiber 212c to be detected by a photodetector connected to the detection optical fiber 212c.

An intensity of the light detected through the detection optical fiber 212c by the photodetector is an intensity reflecting the circuit pattern provided in the semiconductor device S, as described above. Therefore, as the area on the semiconductor device S is scanned by X-Y scanning with the infrared laser beam by the XY scanner 212f, the pattern image P1 or the like of the semiconductor device S can be acquired as a clear image.

The control section 22 has a camera controller 251a, an LSM controller 251b, an OBIRCH controller 251c, and a stage controller 252. Among these, the camera controller 251 a, LSM controller 251 b, and OBIRCH controller 251 c constitute an observation controlling means for controlling operations of the image acquiring means, inspection means, etc. in the observation section 21, thereby controlling the acquisition of the observed image of the semiconductor device S, the setting of observation conditions, etc. executed in the observation section 21.

Specifically, the camera controller 251 a and LSM controller 251b control the operations of the high-sensitivity camera 210 and the LSM unit 212, respectively, to control the acquisition of the observed image of the semiconductor device S. The OBIRCH controller 251c is a controller for acquiring an OBIRCH (Optical Beam Induced Resistance Change) image which can be used as a failure observed image, and extracts an electric current change or the like in the semiconductor device S occurring during the scanning with the laser beam.

The stage controller 252 controls the operation of the XYZ stage 215 in the observation section 21, thereby controlling setting of an observed portion in the semiconductor device S as an inspection portion by the present inspection apparatus 20A, position adjustment thereof, focusing, and so on.

An inspection information processor 23 is provided for these observation section 21 and control section 22. The inspection information processor 23 performs such processing as data collection of the observed image of the semiconductor device S acquired in the observation section 21, supply of inspection information including the pattern image P1 and failure observed image P2, to the failure analysis apparatus 10 (cf. Fig. 1), and so on. It is also possible to adopt a configuration wherein a display device 24 is connected to this inspection information processor 23 as occasion may demand. It is noted that Fig. 6 is illustrated without illustration of the inspection information processor 23 and the display device 24.

A specific example of the failure analysis method by the semiconductor failure analysis apparatus 10 shown in Fig. 1 will be described below with an example of an analysis screen (analysis window) displayed in the display device 40 by the analysis screen display controller 14.

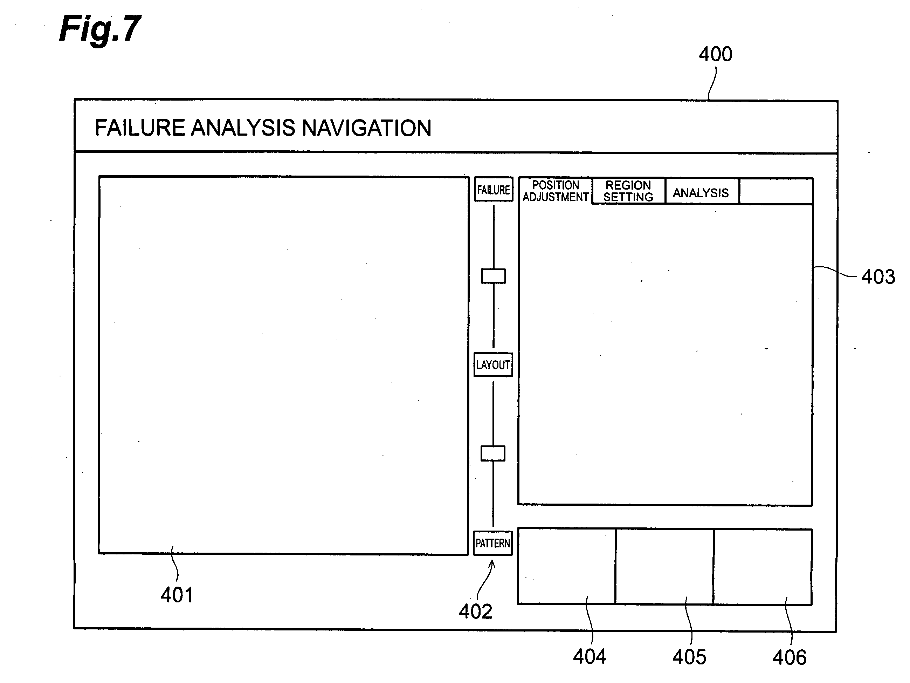

Fig. 7 is a configuration diagram showing an example of an analysis window (failure analysis navigation window) displayed in the display device 40. This analysis window 400 has an image display region 401 used for display of each image to be used in the failure analysis, such as the pattern image P1, failure observed image P2, or layout image P3 of the semiconductor device, which is located on the left side of the screen, and a display adjustment region 402 for giving instructions for adjustment of a display condition for the image in the image display region 401, which is located in the center of the screen.

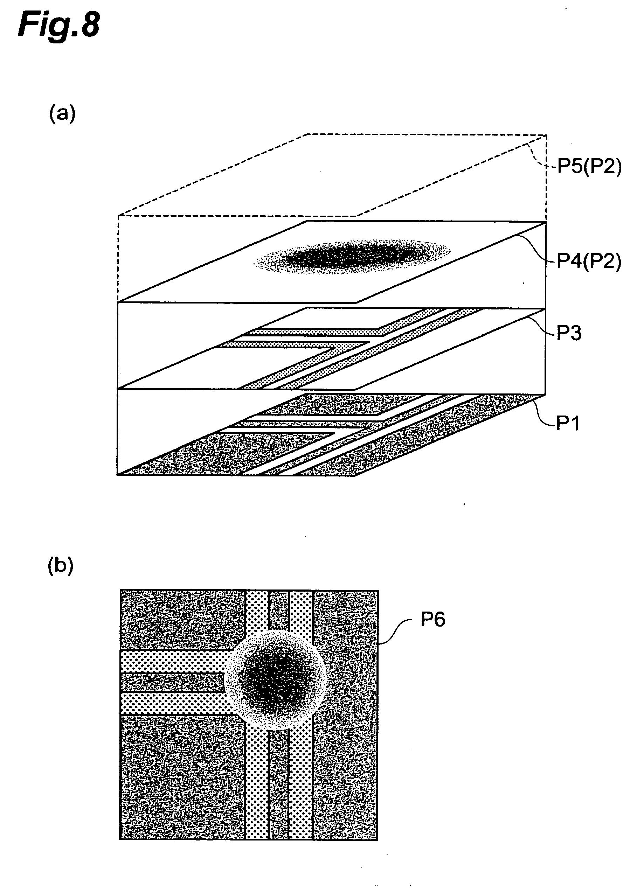

The image display region 401 presents display of a superimposed image P6 in which the pattern image P1, layout image P3, and the emission image P4 being the failure observed image P2 are superimposed, for example, as shown in (a) and (b) in Fig. 8. In combination with the emission image P4, an OBIRCH image P5 being another failure observed image P2 may also be further superimposed. In general, this image display region 401 may be arranged to provide display of various images according to need, e.g., display of one of the pattern image P1, failure observed image P2, and layout image P3.

Regions provided on the right side of the screen in the analysis window 400 are an analysis operation region 403 used for instructions and entry of information necessary for the analysis process carried out in the failure analyzer 13, an inspection information acquisition operation region 404 for controlling acquisition of information from the inspection information supplying apparatus 20, a layout information acquisition operation region 405 for controlling acquisition of information from the layout information supplying apparatus 30, and a communication operation region 406 for controlling a communication state with the supplying apparatus 20, 30. The analysis process executed in the failure analysis apparatus 10 is controlled using these regions 403-406 by an operator.

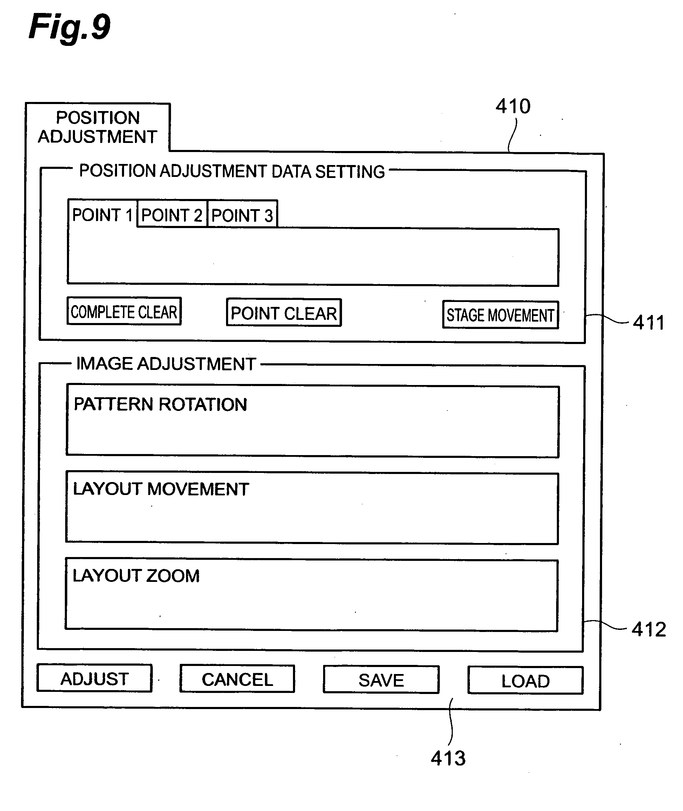

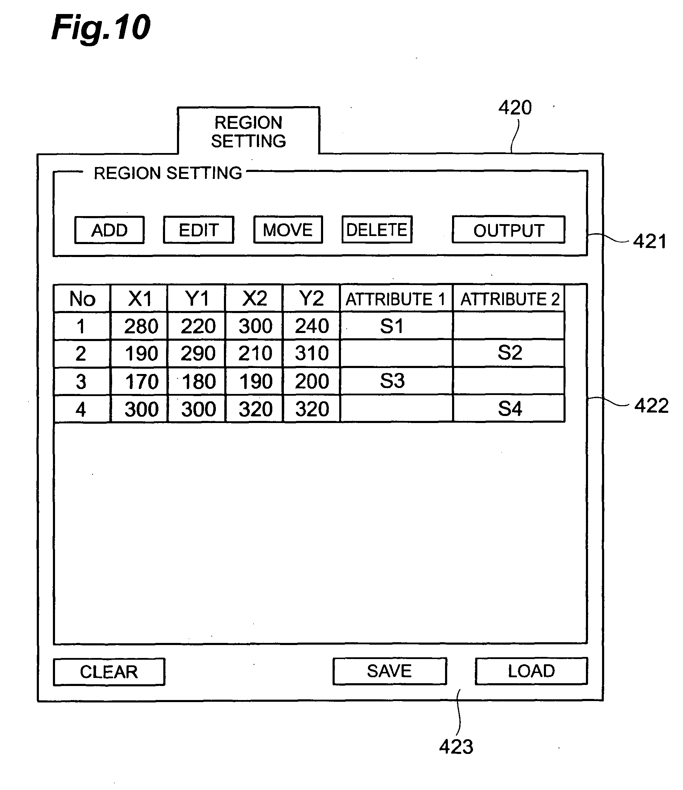

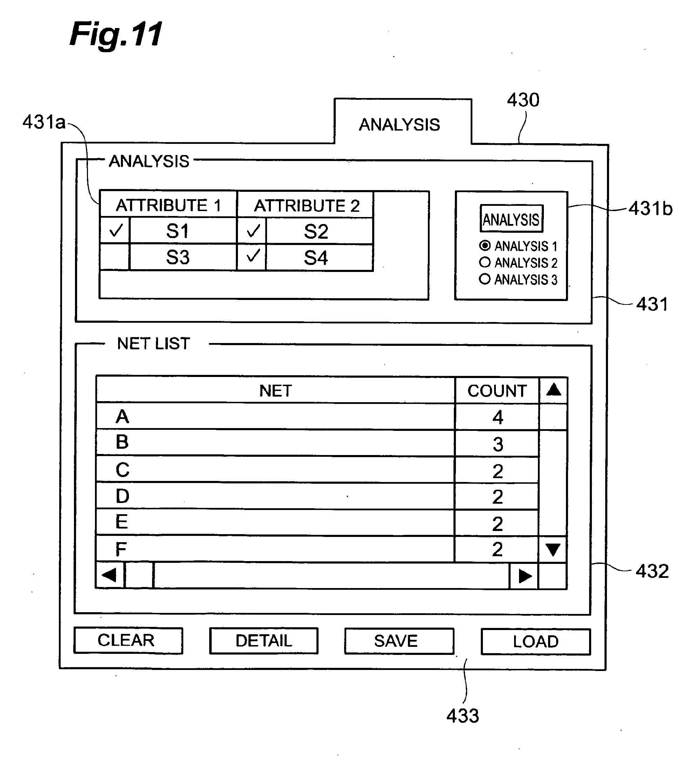

The operation screen displayed in the analysis operation region 403 can be switched among three screens, position adjustment operation screen 410, region setting operation screen 420, and analysis operation screen 430 shown in Figs. 9 to 11, respectively. Among these operation screens, the position adjustment operation screen 410 of Fig. 9 is used in the control of the processing executed in the position adjuster 133 of the failure analyzer 13 (cf. Fig. 2). The region setting operation screen 420 of Fig. 10 is used in control of the processing executed in the region setter 131. The analysis operation screen 430 of Fig. 11 is used in control of the processing executed in the net information analyzer 132 and in the display of the analysis result obtained.

First, the position adjustment operation screen 410 shown in Fig. 9 will be described. In this configuration example, a specific method of position alignment between the observed image P1, P2 and the layout image P3 by the position adjuster 133 is a method of designating three appropriate points in the pattern image P1, designating three corresponding points in the layout image P3, and effecting position adjustment from coordinates of those points. This method may also be modified to designate four or more points and perform the position alignment based thereon according to need.

In corresponding thereto, the operation screen 410 is provided with a position adjustment data setting region 411 for setting three points to be used in the position alignment for each of the pattern image P1 and the layout image P3. This setting of three points can be implemented, for example, by a method of setting the points through manipulation of a mouse on an image displayed in the image display region 401 in the analysis window 400, or by a method of entering coordinates of points to be set, as numerical data. The position adjustment of the images with three points is performed, for example, by θ correction to calculate an inclination between the pattern image P 1 and the layout image P3 from the positions of the three points set, and to incline the pattern image P1 and the failure observed image P2, based thereon.

The operation screen 410 of Fig. 9 is further provided with an image adjustment region 412. This image adjustment region 412 permits the operator to manually carry out fine adjustment of position alignment, by carrying out such operation as rotation of the pattern image P1 (θ correction), movement of the layout image P3 (fine adjustment of position), or zooming of the layout image (enlargement/reduction). A button display region 413 displaying necessary operation buttons is provided below the regions 411, 412.

Next, the region setting operation screen 420 shown in Fig. 10 will be described. This operation screen 420 is provided with an analysis region setting region 421 for giving instructions necessary for setting of a plurality of analysis regions by the region setter 131, and an analysis region display region 422 for displaying information of each analysis region thus set. Fig. 10 shows display of coordinate data corresponding to four analysis regions of analysis regions 1 to 4 in the display region 422.

In this configuration example, two types of attributes, attribute 1 and attribute 2, can be set for each of the analysis regions 1 to 4. Fig. 10 shows an example wherein attribute "S1" is set as attribute 1 for the analysis region 1, attribute "S2" as attribute 2 for the analysis region 2, attribute "S3" as attribute 1 for the analysis region 3, and attribute "S4" as attribute 2 for the analysis region 4. A button display region 423 displaying necessary operation buttons is provided below the regions 421, 422.

Each of the above-described attributes is stored as linked with positional information of the analysis region (e.g., left upper and right lower coordinates of a rectangular analysis region). These pieces of information can be saved and read into and from a file or the like. For example, in a case where the analysis is carried out for the same positions of different devices, the information of the saved file is loaded, which eliminates a need for again drawing the regions and again setting their attributes, and which is useful in identifying which attribute (e.g., nondefective emission or the like) is owned by a reaction part thereof.

Next, the analysis operation screen 430 shown in Fig. 11 will be described. This operation screen 430 is provided with a failure analysis instruction region 431 for giving instructions necessary for execution of the failure analysis by the net information analyzer 132, and an analysis result display region 432 for displaying the analysis result obtained. In Fig. 11 the display region 432 presents the display of a list of names of nets obtained as an analysis result, and counts of passages of the nets through the analysis regions (net list). A button display region 433 displaying necessary operation buttons is provided below the regions 431, 432.

The failure analysis instruction region 431 is provided with a first instruction region 431 a for selection of whether each analysis region is to be used in the failure analysis, for the attributes set for the respective analysis regions, and a second instruction region 431 b for giving instructions for a specific condition of analysis (analysis 1-analysis 3) and for execution of the analysis. A method of selecting the analysis regions in this case can be a selection method of performing the failure analysis, using the analysis regions with checked attributes in the first instruction region 431 a (attributes S1, S2, and S4 in the example of Fig. 11) and the analysis regions without any attribute set and not using the analysis region with the attribute not checked in the first instruction region 431a (attribute S3 in the example of Fig. 11), for example, in the failure analysis by the net information analyzer 132.

The configuration as described above is useful to various cases, for example, a case where, for each of parts to constantly emit light regardless of the presence/absence of failure (e.g., parts of nondefective emissions), an analysis region with an attribute indicating it is set and the analysis region thereof is eliminated from objects of failure analysis. This can improve the efficiency of analysis of failure of the semiconductor device.

Furthermore, the second instruction region 431 b for instructions for the analysis condition is preferably configured in a configuration where a specific condition for extraction of nets can be set; for example, where the failure observed image is an emission image, only nets having wiring ends in the analysis region are extracted; where the failure observed image is an OBIRCH image, nets passing the interior of the analysis region are also extracted in addition to the nets having wiring ends in the analysis region. Such condition setting may also be arranged to be automatically selected according to the type of the failure observed image or the like.

Specifically, nets constituting a semiconductor device are routed so as to connect circuits such as transistors, and there are end points of the nets connected to the transistors. Emission of light is mainly weak emission due to switching of the transistors, and abnormal emission of light is induced mainly by a leak current of the transistors. The emission due to switching also occurs in nondefectives, and it can be discriminated by adding an attribute to the analysis region. In such an emission image, a net with an end point existing in a reaction region of the emission image is often associated with a circuit to cause emission of light, and a net passing the reaction region is not associated with the circuit to cause emission of light. Therefore, in the case of the failure analysis using the emission image, it is preferable to extract only the nets having the wiring end in the analysis region as described above.

On the other hand, the OBIRCH image is focused mainly on detection of a failure in the nets and also permits detection of a failure in transistor parts or the like. In the failure analysis using the OBIRCH image, it is thus preferable to also extract the nets passing the interior of the analysis region in addition to the nets having the wiring end in the analysis regions as described above.

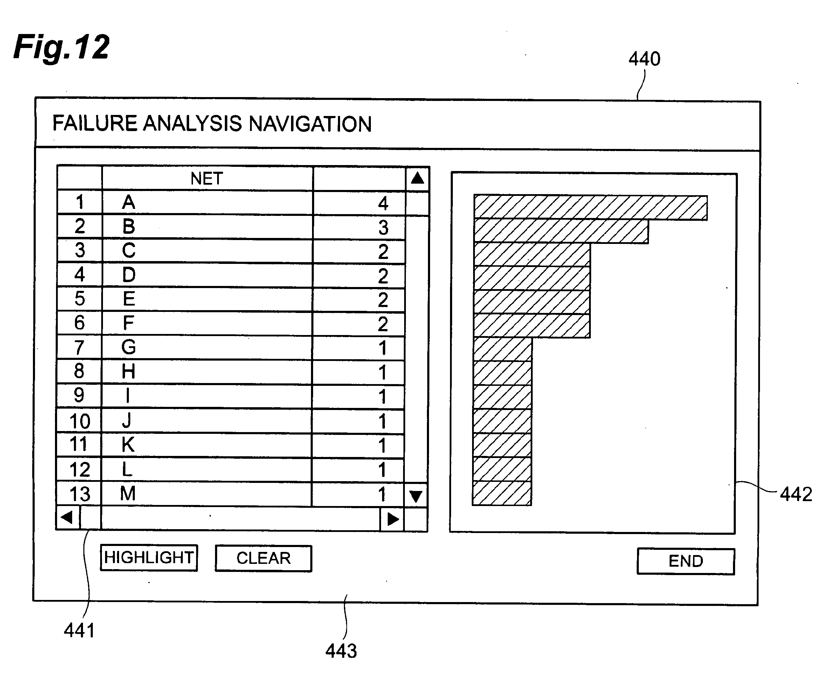

In the present configuration example, a net list display window 440 shown in Fig. 12 can also be displayed by a "detail" button in the button display region 433. This display window 440 has a net list display region 441 located on the left side of the screen, and a graph display region 442 displaying a graph (histogram) of the net list, located on the right side of the screen. The use of this display window 440 facilitates the operator's grasping the result of the failure analysis obtained.

The display window 440 of Fig. 12 enables highlight display of a selected net on the layout image by a "highlight" button in a button display region 443 in the lower part. In a case where the additional analysis information is acquired by the additional analysis information acquirer 134 as described above with Fig. 2, the nets determined to be defective by the analysis information may be colored in the net list display region 441 or in the graph display region 442. Where a net on the layout image is selected through such input means as a keyboard or a mouse, an analysis region where the net passes may be displayed with a different color to notify the operator of it.

The semiconductor failure analysis apparatus, failure analysis method, and failure analysis program according to the present invention are not limited to the above-described embodiment and configuration examples, but can be modified in various ways. For example, the above-described analysis screen and operation screens are an example of screens applicable to the semiconductor failure analysis apparatus, but they may be selected from a variety of analysis screens according to a specific failure analysis method or the like, without having to be limited to such screens. The method of setting the analysis region or the like may also be selected from various methods, without having to be limited to the above-described specific example.

The semiconductor failure analysis apparatus according to the above embodiment is a semiconductor failure analysis apparatus for analyzing a failure of a semiconductor device, using an observed image thereof, comprising: (1) inspection information acquiring means for acquiring a failure observed image containing reaction information arising from a failure, acquired by conducting an inspection about the failure, as an observed image of the semiconductor device; (2) layout information acquiring means for acquiring layout information of the semiconductor device; (3) failure analyzing means for analyzing the failure of the semiconductor device with reference to the failure observed image and the layout information; and (4) information display controlling means for letting display means display information about an analysis of the failure of the semiconductor device, (5) wherein the failure analyzing means has region setting means for setting an analysis region in correspondence to the reaction information with reference to the failure observed image, and net information analyzing means for extracting a net passing the analysis region, from a plurality of nets included in a layout of the semiconductor device, and (6) wherein the information display controlling means lets the display means display information about a result of the analysis of the failure of the semiconductor device obtained by the region setting means and the net information analyzing means.

The semiconductor failure analysis method is a semiconductor failure analysis method of analyzing a failure of a semiconductor device, using an observed image thereof, comprising: (a) an inspection information acquiring step of acquiring a failure observed image containing reaction information arising from a failure, acquired by conducting an inspection about the failure, as an observed image of the semiconductor device; (b) a layout information acquiring step of acquiring layout information of the semiconductor device; (c) a region setting step of setting an analysis region in correspondence to the reaction information with reference to the failure observed image; (d) a net information analyzing step of extracting a net passing the analysis region, from a plurality of nets included in a layout of the semiconductor device; and (e) an information displaying step of letting display means display information about a result of the analysis of the failure of the semiconductor device obtained by the region setting step and the net information analyzing step.

The semiconductor failure analysis program is a program for letting a computer execute a semiconductor failure analysis of analyzing a failure of a semiconductor device, using an observed image thereof, the semiconductor failure analysis program letting the computer execute: (a) an inspection information acquiring process of acquiring a failure observed image containing reaction information arising from a failure, acquired by conducting an inspection about the failure, as an observed image of the semiconductor device; (b) a layout information acquiring process of acquiring layout information of the semiconductor device; (c) a region setting process of setting an analysis region in correspondence to the reaction information with reference to the failure observed image; (d) a net information analyzing process of extracting a net passing the analysis region, from a plurality of nets included in a layout of the semiconductor device; and (e) an information displaying process of letting display means display information about a result of the analysis of the failure of the semiconductor device obtained by the region setting process and the net information analyzing process.

The aforementioned failure analysis apparatus is preferably configured as follows: the region setting means sets a plurality of analysis regions in correspondence to the reaction information with reference to the failure observed image, and the net information analyzing means extracts a net passing each of the plurality of analysis regions from the plurality of nets, and acquires a passage count of the net through the analysis regions.

Similarly, the failure analysis method is preferably configured as follows: the region setting step comprises setting a plurality of analysis regions in correspondence to the reaction information with reference to the failure observed image, and the net information analyzing step comprises extracting a net passing each of the plurality of analysis regions from the plurality of nets, and acquiring a passage count of the net through the analysis regions.

Similarly, the failure analysis program is preferably configured as follows: the region setting process comprises setting a plurality of analysis regions in correspondence to the reaction information with reference to the failure observed image, and the net information analyzing process comprises extracting a net passing each of the plurality of analysis regions from the plurality of nets, and acquiring a passage count of the net through the analysis regions.

By adopting this configuration of setting the plurality of analysis regions in correspondence to the reaction information in the failure observed image and acquiring the passage count through the analysis regions of each net forming the semiconductor device, it is feasible to estimate a net with a high possibility of failure in the semiconductor device, by extracting a net with a large passage count through the analysis regions. Therefore, it becomes feasible to further securely and efficiently perform the analysis of the failure of the semiconductor device with the use of the failure observed image.

The failure analysis apparatus is preferably configured as follows: the inspection information acquiring means acquires a pattern image being a normal observed image, in addition to the failure observed image, the layout information acquiring means acquires a layout image as the layout information, and the failure analyzing means has position adjusting means for implementing position adjustment between the observed images including the pattern image and the failure observed image, and the layout image with reference to the pattern image and the layout image.

Similarly, the failure analysis method is preferably configured as follows: the inspection information acquiring step comprises acquiring a pattern image being a normal observed image, in addition to the failure observed image, the layout information acquiring step comprises acquiring a layout image as the layout information, and the failure analysis method comprises a position adjustment step of implementing position adjustment between the observed images including the pattern image and the failure observed image, and the layout image with reference to the pattern image and the layout image.

Similarly, the failure analysis program is preferably configured as follows: the inspection information acquiring process comprises acquiring a pattern image being a normal observed image, in addition to the failure observed image, the layout information acquiring process comprises acquiring a layout image as the layout information, and the failure analysis program lets the computer execute a position adjustment process of implementing position adjustment between the observed images including the pattern image and the failure observed image, and the layout image with reference to the pattern image and the layout image.

When the position adjustment is carried out with respect to the layout image by use of the pattern image obtained in the state in which it is aligned with the failure observed image as described above, it is feasible to improve the accuracy of the analysis of the failure of the semiconductor device with the use of the failure observed image.

The failure analysis apparatus is preferably configured so that the region setting means is arranged to enable setting of an attribute for the analysis region. Similarly, the failure analysis method is preferably configured so that the region setting step enables setting of an attribute for the analysis region. Similarly, the failure analysis program is preferably configured so that the region setting process enables setting of an attribute for the analysis region. Where a plurality of analysis regions are set, the attribute is preferably allowed to be set for each of the plurality of analysis regions.

In this case, the failure analysis apparatus may be configured so that the net information analyzing means selects whether the analysis region is to be used in extraction of the net, with reference to the attribute set for the analysis region. Similarly, the failure analysis method may be configured so that the net information analyzing step comprises selecting whether the analysis region is to be used in extraction of the net, with reference to the attribute set for the analysis region. Similarly, the failure analysis program may be configured so that the net information analyzing process comprises selecting whether the analysis region is to be used in extraction of the net, with reference to the attribute set for the analysis region. Where a plurality of analysis regions are set, it is preferable to select whether each of the analysis regions is to be used in extraction of the net and in acquisition of the passage count, with reference to the attributes set for the respective analysis regions, in the net information analysis.

The failure analysis apparatus may be configured so that the failure analyzing means has additional analysis information acquiring means for acquiring additional analysis information about the failure of the semiconductor device acquired by another analysis method. Similarly, the failure analysis method may be arranged to comprise an additional analysis information acquiring step of acquiring additional analysis information about the failure of the semiconductor device acquired by another analysis method. Similarly, the failure analysis program may be arranged to let the computer execute an additional analysis information acquiring process of acquiring additional analysis information about the failure of the semiconductor device acquired by another analysis method.

Concerning the analysis result to be displayed in the display means, it is preferable to let the display means display a net list to display a list of nets extracted by the net information analysis. Where a plurality of analysis regions are set, it is preferable to let the display means display a net list to display a list of nets extracted by the net information analysis (e.g., names of nets), and passage counts of the nets through the analysis regions (e.g., counts indicating the numbers of passages), as the analysis result.

### Industrial Applicability

The present invention can be applied as the semiconductor failure analysis apparatus, failure analysis method, and failure analysis program capable of securely and efficiently performing the analysis of the failure of the semiconductor device with the use of the failure observed image.

## Claims

1. A semiconductor failure analysis apparatus for analyzing a failure of a semiconductor device, using an observed image thereof, comprising:
inspection information acquiring means for acquiring a failure observed image containing reaction information arising from a failure, acquired by conducting an inspection about the failure, as an observed image of the semiconductor device;
layout information acquiring means for acquiring layout information of the semiconductor device;
failure analyzing means for analyzing the failure of the semiconductor device with reference to the failure observed image and the layout information; and
information display controlling means for letting display means display information about an analysis of the failure of the semiconductor device,
wherein the failure analyzing means has region setting means for setting an analysis region in correspondence to the reaction information with reference to the failure observed image, and net information analyzing means for extracting a net passing the analysis region, from a plurality of nets included in a layout of the semiconductor device, and
wherein the information display controlling means lets the display means display information about a result of the analysis of the failure of the semiconductor device obtained by the region setting means and the net information analyzing means.

2. The failure analysis apparatus according to Claim 1, wherein the region setting means sets a plurality of said analysis regions in correspondence to the reaction information with reference to the failure observed image, and wherein the net information analyzing means extracts a net passing each of the plurality of analysis regions, from the plurality of nets, and acquires a passage count of the net through the analysis regions.

3. The failure analysis apparatus according to Claim 1 or 2, wherein the inspection information acquiring means acquires a pattern image being a normal observed image, in addition to the failure observed image, and the layout information acquiring means acquires a layout image as the layout information, and
wherein the failure analyzing means has position adjusting means for implementing position adjustment between the observed images including the pattern image and the failure observed image, and the layout image with reference to the pattern image and the layout image.

4. The failure analysis apparatus according to any one of Claims 1 to 3, wherein the region setting means is arranged to enable setting of an attribute for the analysis region.

5. The failure analysis apparatus according to Claim 4, wherein the net information analyzing means selects whether the analysis region is to be used in extraction of the net, with reference to the attribute set for the analysis region.

6. The failure analysis apparatus according to any one of Claims 1 to 5, wherein the failure analyzing means has additional analysis information acquiring means for acquiring additional analysis information about the failure of the semiconductor device acquired by another analysis method.

7. A semiconductor failure analysis method of analyzing a failure of a semiconductor device, using an observed image thereof, comprising:
an inspection information acquiring step of acquiring a failure observed image containing reaction information arising from a failure, acquired by conducting an inspection about the failure, as an observed image of the semiconductor device;
a layout information acquiring step of acquiring layout information of the semiconductor device;
a region setting step of setting an analysis region in correspondence to the reaction information with reference to the failure observed image;
a net information analyzing step of extracting a net passing the analysis region, from a plurality of nets included in a layout of the semiconductor device; and
an information displaying step of letting display means display information about a result of the analysis of the failure of the semiconductor device obtained by the region setting step and the net information analyzing step.

8. The failure analysis method according to Claim 7, wherein the region setting step comprises setting a plurality of said analysis regions in correspondence to the reaction information with reference to the failure observed image, and
wherein the net information analyzing step comprises extracting a net passing each of the plurality of analysis regions, from the plurality of nets, and acquiring a passage count of the net through the analysis regions.

9. The failure analysis method according to Claim 7 or 8, wherein the inspection information acquiring step comprises acquiring a pattern image being a normal observed image, in addition to the failure observed image, and the layout information acquiring step comprises acquiring a layout image as the layout information,
the failure analysis method comprising a position adjustment step of implementing position adjustment between the observed images including the pattern image and the failure observed image, and the layout image with reference to the pattern image and the layout image.

10. The failure analysis method according to any one of Claims 7 to 9, wherein the region setting step enables setting of an attribute for the analysis region.

11. The failure analysis method according to Claim 10, wherein the net information analyzing step comprises selecting whether the analysis region is to be used in extraction of the net, with reference to the attribute set for the analysis region.

12. The failure analysis method according to any one of Claims 7 to 11, comprising an additional analysis information acquiring step of acquiring additional analysis information about the failure of the semiconductor device acquired by another analysis method.

13. A program for letting a computer execute a semiconductor failure analysis of analyzing a failure of a semiconductor device, using an observed image thereof,
the semiconductor failure analysis program letting the computer execute:
an inspection information acquiring process of acquiring a failure observed image containing reaction information arising from a failure, acquired by conducting an inspection about the failure, as an observed image of the semiconductor device;
a layout information acquiring process of acquiring layout information of the semiconductor device;
a region setting process of setting an analysis region in correspondence to the reaction information with reference to the failure observed image;
a net information analyzing process of extracting a net passing the analysis region, from a plurality of nets included in a layout of the semiconductor device; and
an information displaying process of letting display means display information about a result of the analysis of the failure of the semiconductor device obtained by the region setting process and the net information analyzing process.

14. The failure analysis program according to Claim 13, wherein the region setting process comprises setting a plurality of said analysis regions in correspondence to the reaction information with reference to the failure observed image, and
wherein the net information analyzing process comprises extracting a net passing each of the plurality of analysis regions, from the plurality of nets, and acquiring a passage count of the net through the analysis regions.

15. The failure analysis program according to Claim 13 or 14, wherein the inspection information acquiring process comprises acquiring a pattern image being a normal observed image, in addition to the failure observed image, and the layout information acquiring process comprises acquiring a layout image as the layout information,
the failure analysis program letting the computer execute a position adjustment process of implementing position adjustment between the observed images including the pattern image and the failure observed image, and the layout image with reference to the pattern image and the layout image.

16. The failure analysis program according to any one of Claims 13 to 15, wherein the region setting process enables setting of an attribute for the analysis region.

17. The failure analysis program according to Claim 16, wherein the net information analyzing process comprises selecting whether the analysis region is to be used in extraction of the net, with reference to the attribute set for the analysis region.

18. The failure analysis program according to any one of Claims 13 to 17, the program letting the computer execute an additional analysis information acquiring process of acquiring additional analysis information about the failure of the semiconductor device acquired by another analysis method.

19. The failure analysis program according to any one of Claims 13 to 18, wherein the information displaying process comprises letting the display means display a net list to display a list of nets extracted by the net information analyzing process, as the analysis result.
